# EUROPEAN PATENT APPLICATION

(11) **EP 2 657 987 A1**
(43) Date of publication of application: **30.10.2013**
(21) Application number: 11851586.5
(22) Date of filing: 16.12.2011
(51) Int. Cl.: H01L 31/052

(54) **MULTI-BAND LIGHT COLLECTING AND ENERGY CONVERSION MODULE**

(30) Priority: 21.12.2010 CN 201010609232
(71) Applicant: Industrial Technology Research Institute, Chutung Hsinchu 31040, Taiwan (TW)
(72) Inventor: LIN, Hui-Hsiung, Miaoli County Taiwan (TW); LIN, Chun-Ting, New Taipei City Taiwan (TW)
(74) Representative: Viering, Jentschura & Partner
(86) International application number: PCT/CN2011/084110
(87) International publication number: WO 2012/083821

(57) **Abstract**

A multi-band concentrator and energy conversion module includes a multi-band solar concentrator and an energy conversion device. The multi-band solar concentrator is used for splitting an incident light into a plurality of light beams and for concentrating the plurality of light beams on a plurality of primary spots separated from each other, respectively. The energy conversion device includes a plurality of energy conversion units being corresponding to and disposed at the primary spots separated from each other individually. Each of the energy conversion units has an individual absorption spectrum peak corresponding to a wavelength of the light beam of the primary spot where the energy conversion unit is disposed.

## Description

### BACKGROUND

### Technical Field

The present disclosure relates to a multi-band concentrator and energy conversion module for the sunlight or ambient light being concentrated according to the corresponding wavelength and converted into the other energy.

### Related Art

At present, there are many solar cell technologies in the world, but no one has an absorption spectrum which can fit the solar irradiance spectrum.

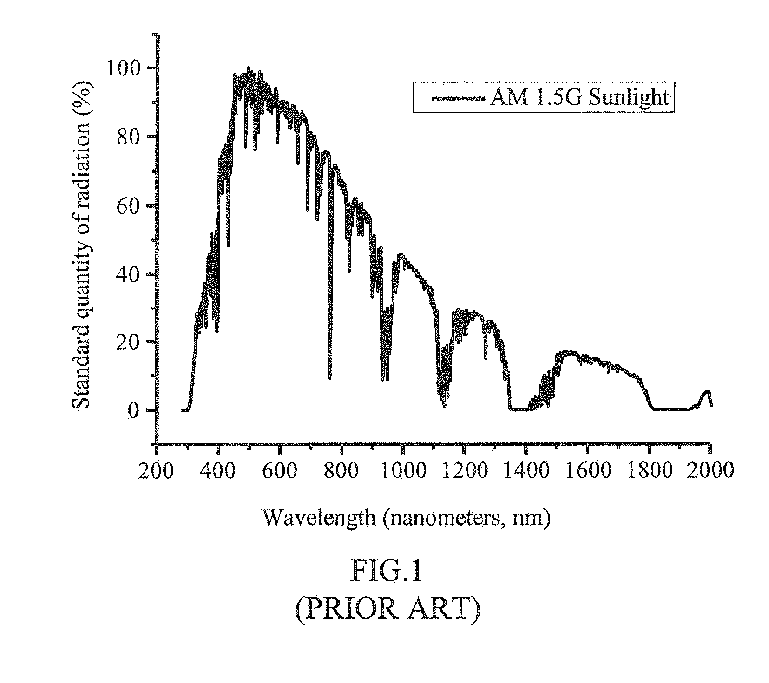

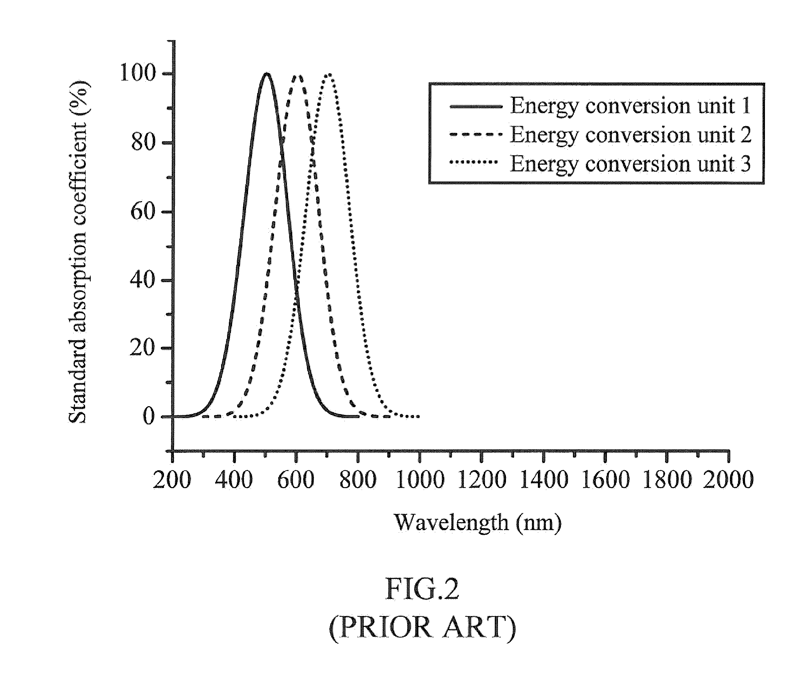

FIG. 1 is a solar irradiance spectrum of the sunlight (AM 1.5G). FIG. 2 is an absorption spectrum of the three solar cells. Referring to FIGs. 1 and 2, most solar cells can absorb the light (that is, the incident light or called as incident light) with the specific band of the solar irradiance spectrum.

Therefore, with the available solar cell technologies, the sunlight cannot be absorbed effectively, and a multi-band sunlight absorption technology is required to absorb the sunlight more efficiently.

It is known that the multi-band sunlight absorption technology is based on the tandem solar cell technology. The tandem solar cell technology, which stacks two or three solar cells in tandem, can increase the absorption spectra of the solar cells. However, because of the limitation of the transmittance of the material, the incident intensity of the sunlight is decreased at the lower solar cell and the absorption intensity of the lower cell is also reduced.

Furthermore, the different solar cells have the different lattice constants. The mismatch of the lattice constants tends to introduce lattice at the interface and the photocurrent concentration is reduced. Therefore, a buffer layer needs to be disposed at the interface to reduce the resistance and the lattice mismatch while the cost and complexity of the production will increase at the same time. With the stack number increasing, the cost and complexity of the production will increase, too. However, the improved efficiency will not increase linearly and the yield of the process will also be reduced.

Because of the shortage of solar-grade silicon feedstock, the use of the concentrator is important. The concentration ratio is defined as the ratio of the illuminated area of the concentrator to that of the solar cell at the focus. The higher concentration ratio the solar power system is, the less solar cell materials it uses.

According to the multi-band sunlight absorption technology, the sunlight is concentrated to the solar cell through arched Fresnel lens, so as to increase the intensity of incident light and reduce the use of photovoltaic materials. However, the absorption spectra of the solar cell do not cover all the solar irradiance spectra and unabsorbed solar irradiance spectra converts into heat. Thus, temperature of base plate of the solar cell is increased, thereby reducing the conversion efficiency of the solar cell. In order to dissipate the heat from a base plate, a heat sink is disposed additionally, but the design of the heat sink increases the cost and complexity of the solar power system.

According to another multi-band sunlight absorption technology, an off-axis Fresnel lens made of high dispersion material is utilized to concentrate sunlight on solar cells. However, according to the characteristics of the off-axis Fresnel lens, light with different wavelengths is concentrated at different locations in an axial direction of light incidence. In the following, solar cells with different absorption spectra are placed in the vicinity of the axial direction of light incidence, so as to enable the light to have different wavelengths to be absorbed by the different solar cells. However, such design causes problems that the incident angle of the incident light on the solar cells is too big to have good conversion efficiency, and the high chromatic dispersion materials are not easy to obtain.

### SUMMARY

An embodiment discloses a multi-band concentrator and energy conversion module comprising a multi-band solar concentrator and an energy conversion device. The multi-band solar concentrator is used for splitting an incident light into a plurality of light beams and concentrating the plurality of light beams on a plurality of primary spots separated from each other, respectively. The energy conversion device comprises a plurality of energy conversion units being corresponding to and disposed at the primary spots separated from each other individually. Each of the energy conversion units has an individual absorption spectrum peak corresponding to a wavelength of the light beam of the primary spot where the energy conversion unit is disposed.

Another embodiment discloses a multi-band concentrator and energy conversion module comprising a multi-band solar concentrator and an energy conversion device. The multi-band solar concentrator comprises a light concentration component and an optic grating disposed on a surface of the light concentration component. The energy conversion device comprises a plurality of energy conversion units disposed on a light concentration surface of the light concentration component with sides adjacent to each other. A light receiving surface of the energy conversion units faces the light concentration component.

Yet another embodiment discloses a multi-band concentrator and energy conversion module comprising a multi-band solar concentrator and an energy conversion device. The multi-band solar concentrator is used for splitting and concentrating an incident light according to wavelengths, and the multi-band solar concentrator comprises a light concentration component for concentrating the incident light on a light concentration surface and an optic grating for splitting the incident light according to bands. The energy conversion device comprises a plurality of energy conversion units disposed on the light concentration surface of the light concentration component. A light receiving surface of the energy conversion device faces the light concentration component. After the incident light is split and concentrated by the multi-band solar concentrator, the incident light forms a plurality of light beams having the different bands to be incident on the energy conversion device.

### BRIEF DESCRIPTION OF THE DRAWINGS

The present disclosure will become more fully understood from the detailed description given herein below for illustration only, and thus are not limitative of the present disclosure, and wherein:
FIG. 1 is a solar irradiance spectrum of the sunlight (AM 1.5G);
FIG. 2 is an absorption spectrum of three energy conversion units;
FIG. 3 is a schematic structural view of a multi-band concentrator and energy conversion module according to a first embodiment;
FIG. 4 is a schematic structural view of a multi-band concentrator and energy conversion module according to a second embodiment;
FIG. 5 is a schematic structural view of a multi-band concentrator and energy conversion module according to a third embodiment;
FIG. 6 is a schematic structural view of a multi-band concentrator and energy conversion module according to a fourth embodiment;
FIG. 7 is a schematic structural view of a multi-band concentrator and energy conversion module according to a fifth embodiment;
FIG. 8 is a schematic structural view of a multi-band concentrator and energy conversion module according to a sixth embodiment;
FIG. 9 is a schematic structural view of an example of a multi-band concentrator and energy conversion module according to an embodiment;
FIG. 10 is a detailed schematic structural view of an optic grating according to an embodiment;
FIG. 11 is a schematic view of secondary spots and an overall spot according to an embodiment;
FIG. 12 is a schematic structural view of multiple multi-band concentrator and energy conversion modules according to the first embodiment; and
FIG. 13 is a schematic structural view of a multi-band concentrator and energy conversion module according to a seventh embodiment.

### DETAILED DESCRIPTION

In the following detailed description, for purposes of explanation, numerous specific details are set forth in order to provide a thorough understanding of the disposed embodiments. It will be apparent, however, that one or more embodiments may be practiced without these specific details, In other instances, well-known structures and devices are schematically shown in order to simplify the drawing.

In the present disclosure, a multi-band solar concentrator is used for splitting an incident light such as sunlight or other light into light beams having different bands, and concentrating the light beams on different positions in a horizontal direction of the light incidence, so as to form different spots (or called as concentrated spots or primary spots). The light beams having the different bands may refer as a different range of light spectrum or of specific light wavelengths. In the following, for the convenience of description, the sunlight is taken as an example; however, the embodiments are not limited to this, and ambient light or other lights are other examples.

An energy conversion unit is disposed correspondingly on each spot. Here, the energy conversion unit may be a photovoltaic conversion component (or called as photovoltaic component) or a thermoelectric conversion component, but not limited to the above-mentioned components or units. The term of the above-mentioned corresponding arrangement may be a correspondence of an absorption spectrum peak of the energy conversion unit with the band (wavelength) of the light beam of the spot (note: the energy conversion units have the different absorption spectrum peaks). For example, if the absorption spectrum peak of the energy conversion unit is 500 nanometers (nm), the energy conversion unit covering the peak in the band of the light beam may be disposed on the spot where the light beam covering or overlapping 500 nm is concentrated on. In this embodiment, each of the energy conversion units may have good conversion efficiency, so the total energy conversion efficiency is improved, and generation of heat is reduced as well. As the multi-band solar concentrator has a characteristic of good light concentration, a light concentration ratio may be increased, and the use of the energy conversion unit material may be reduced.

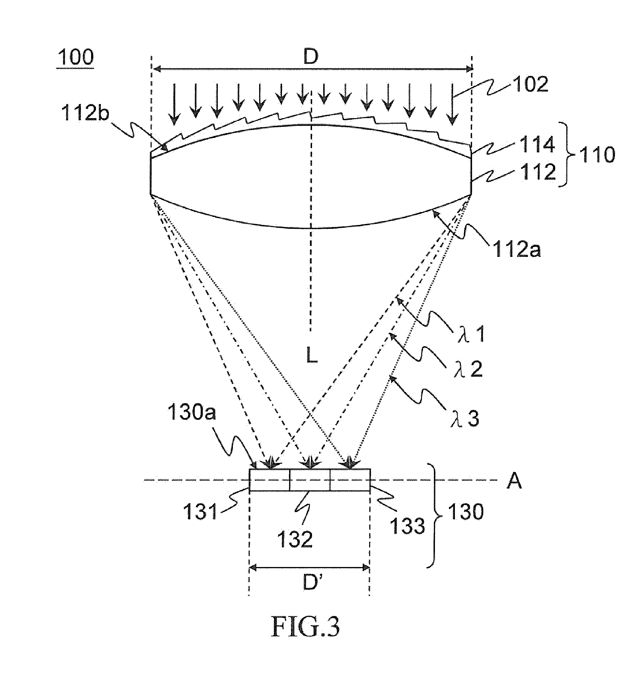

Please refer to FIG. 3, which is a schematic view of a multi-band concentrator and energy conversion module according to one embodiment. A multi-band concentrator and energy conversion module 100 comprises a multi-band solar concentrator 110 and an energy conversion device 130. The multi-band solar concentrator 110 comprises an optic grating 114 and a light concentration component 112. The optic grating 114 is disposed on a surface of the light concentration component 112. The light concentration component 112 of the multi-band solar concentrator 110 is used for concentrating an incident light on a light concentration surface A. The optic grating 114 splits the incident light incident on the multi-band solar concentrator 110 according to the bands to form multiple light beams. For example, incident sunlight 102 is divided (or split) into three light beams and each of the three light beams corresponds to the respective band according to different wavelengths λ₁, λ₂ and λ_{3.} For example, the light beams with the three bands have specific wavelengths respectively, but not limited to the embodiments. In other embodiments, three light beams may also have three respective bands with different wavelength ranges, for example, the light beams with three bands with central wavelengths being λ₁, λ₂ and λ₃. The multi-band solar concentrator 110 may first split and then concentrate the sunlight 102. In other embodiments, the multi-band solar concentrator 110 may first concentrate and then split the sunlight 102. The purpose of the embodiments may both be achieved by the two kinds of above-mentioned processes. In this embodiment, the sunlight 102 is first split and then concentrated.

In this embodiment, the light concentration surface A is a plane, but is not limited thereto. The shape of the light concentration surface A may be varied in correspondence with a light concentration characteristic of the light concentration component 112. For example, the light concentration surface A may be a curved surface or multiple sequentially connected line segments.

The energy conversion device 130 comprises multiple photovoltaic conversion components or thermoelectric conversion components, and the energy conversion units have different absorption spectrum peaks to the light (light energy). In this embodiment, the energy conversion device 130 comprises three energy conversion units 131, 132, 133, and the energy conversion units 131, 132, 133 have different absorption bands (absorption spectrum peaks). The energy conversion units 131, 132, 133 are disposed with sides adjacent to each other. The absorption band of each of the energy conversion unit 132/133 follows the absorption band of the energy conversion unit 131/132, that is, the absorption bands of the energy conversion units 131, 132, 133 may not be overlapped with each other. The energy conversion device 130 is disposed on the light concentration surface A of the light concentration component 112, and a light receiving surface 130a of the energy conversion device 130 (that is, the light receiving surface 130a of each of the energy conversion units 131, 132, 133) faces the light concentration component 112, and the concentrated light (after the light passes through the light concentration component 112) may be incident on the energy conversion units 131, 132, 133. Moreover, the arrangement of the energy conversion units 131, 132, 133 of the energy conversion device 130 with the sides adjacent to each other is taken as an example, but not limited to this arrangement. Any manner is available as long as the energy conversion device 130 is disposed on the light concentration surface A of the light concentration component 112 and the concentrated light is incident on the energy conversion device 130. Furthermore, the light concentration surface A may form an angle with an optical axis L of the light concentration component 112 and the angle may be between 60° and 120°. In an embodiment, the light concentration surface A may be approximately perpendicular to the optical axis L of the light concentration component 112.

According to this embodiment, after the sunlight passes the optic grating 114 and the light concentration component 112, multiple light beams having different bands are formed. The light beams form primary spots separated from each other on the light concentration surface A, and the energy conversion units 131, 132, 133 are correspondingly disposed on the positions of the primary spots formed by the light beams according to the absorption spectrum peaks. Therefore, the arrangement of the energy conversion units 131, 132, 133 enables the central axes (that is, the vertical incidence axis) of the light receiving surfaces 130a of the energy conversion units 131, 132, 133 to correspond to the optical axes of the light beams. In other words, the angle between the central axes of the light receiving surfaces 130a of the energy conversion units 131, 132, 133 and the optical axes of the corresponding light beams is between 0° and 20° (or between 160° and 180°). In consequence, a good light concentration effect is achieved, thereby further promoting the energy conversion efficiency.

The light concentration component 112 comprises a light-emitting surface 112a and an incident surface 112b. The incident surface 112b is used for receiving the light from an incident light source while the light-emitting surface 112a is used for emitting and concentrating the received light on the light concentration surface A. The area of the light-emitting surface 112a of the light concentration component 112 has a size capable of covering the light receiving surface 130a of the energy conversion device 130. In other words, the light-emitting surface 112a is greater than or equal to that of the light receiving surface 130a. In an embodiment, the width D' of the energy conversion device 130 may be less than or equal to a half of the width D of the light concentration component 112. In another embodiment, the light receiving surface 130a of the energy conversion device 130 is less than or equal to a half of the area vertically projected on a horizontal surface by the light-emitting surface 112a of the light concentration component 112.

The optic grating 114 may be attached to or fabricated on the surface of one side of the light concentration component 112. In other words, the light concentration component 112 and the optic grating 114 may be two independent components or a single part integrally formed. As shown in FIG. 3, in this embodiment, the optic grating 114 is attached to the incident surface 112b of the light concentration component 112. Furthermore, the light concentration component 112 may be a lens, and in this embodiment, the light concentration component 112 is a biconvex lens, but the embodiments are not limited to this type of lens.

When the sunlight 102 enters the multi-band concentrator and energy conversion module 100, the sunlight 102 passes through the multi-band solar concentrator 110, and forms multiple light beams having different bands after being split and being concentrated by the multi-band solar concentrator 110. Then, the split and concentrated sunlight 102 is incident on the energy conversion device 130. In the embodiment of FIG. 3, when the sunlight 102 passes the multi-band solar concentrator 110, the sunlight 102 first enters the optic grating 114, and the incident sunlight 102 is divided into three light beams with different wavelengths by the optic grating 114. Then, the split light beams are incident on the light concentration component 112 through the incident surface 112b, and after being concentrated by the light concentration component 112, the split and concentrated light beams emit (namely, exit) from the light-emitting surface 112a and are concentrated on the primary spots separated from each other according to different wavelengths (λ₁, λ₂ and λ₃) on the light concentration surface A. The energy conversion units 131, 132, 133 of the energy conversion device 130 are disposed on the primary spots separated from each other, respectively. Particularly, the energy conversion units 131, 132, 133 are disposed on the primary spots separated from each other where the light beams are concentrated and have the different bands corresponding to absorption spectrum peaks of the energy conversion units 131, 132, 133. That is to say, the absorption spectrum peaks of the energy conversion units 131, 132, 133 correspond to the wavelengths (λ₁, λ₂ and λ₃) of the lights of the primary spots separated from each other. In other words, the absorption bands of the energy conversion units 131, 132, 133 cover the corresponding wavelengths (λ₁, λ₂ and λ₃). Alternatively, the corresponding wavelengths (λ₁, λ₂ and λ₃) are at the center point of the absorption spectra of the energy conversion units 131, 132, 133.

In this way, the light concentration component 112 may enable the sunlight 102 (that is the incident light) to be incident on the energy conversion units 131, 132, 133 after the sunlight 102 is concentrated with a small angle of incidence. In an embodiment, the angle of incidence may be between -30° and 30°. Here, the angle of incidence refers to an angle between the incident light beams and normal lines of the light receiving surfaces 130a of the energy conversion units 13, 132, 133.

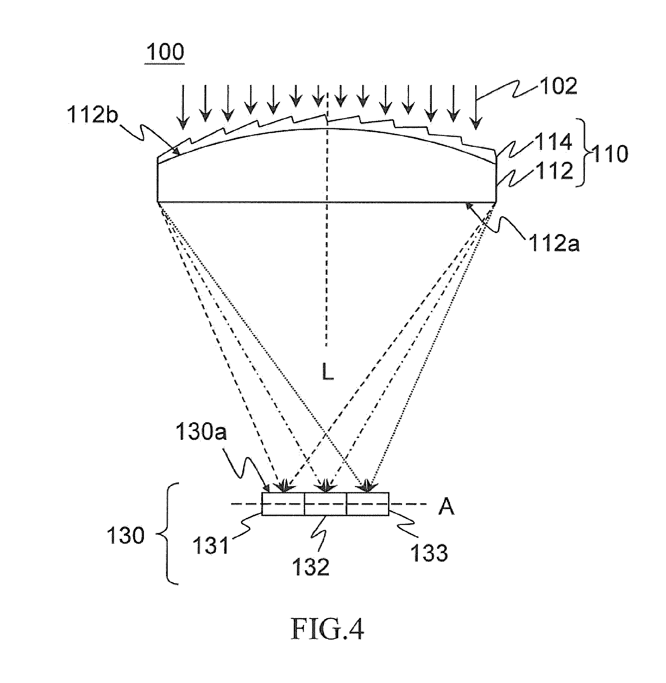

Referring to FIG. 4, which is a schematic structural view of a multi-band concentrator and energy conversion module according to a second embodiment. The difference between this embodiment and the embodiment of FIG. 3 is that a light concentration component 112 in this embodiment is a plano-convex lens. Similarly, when sunlight 102 enters a multi-band concentrator and energy conversion module 100, the sunlight 102 first passes through a multi-band solar concentrator 110, and forms multiple light beams having different bands after the sunlight 102 is split and concentrated by the multi-band solar concentrator 110. At last, the light beams are incident on an energy conversion device 130.

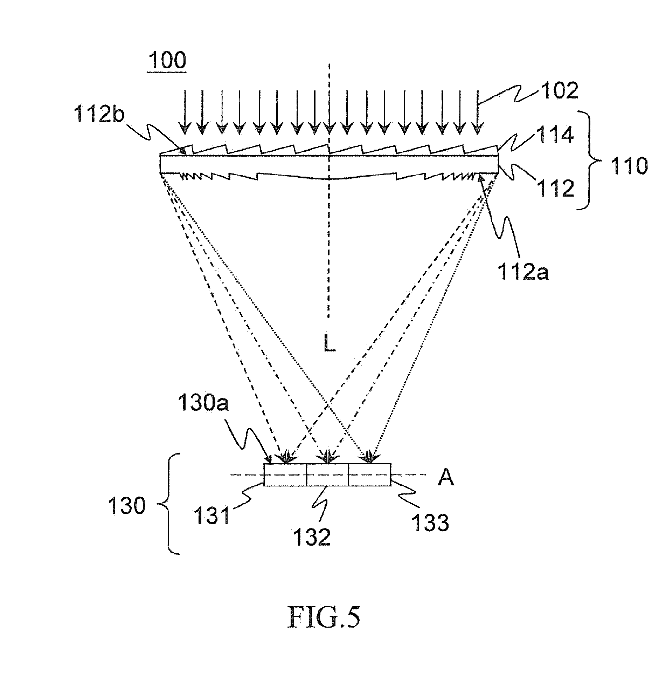

Referring to FIG. 5, which is a schematic structural view of a multi-band concentrator and energy conversion module according to a third embodiment. The difference between this embodiment and the embodiments of FIGs. 3 and 4 is that a light concentration component 112 used in this embodiment is a Fresnel lens. In this embodiment, the Fresnel lens is a two-dimensional light concentration Fresnel lens. Furthermore, in other embodiments, the Fresnel lens may also be a one-dimensional light concentration type. Similarly, when sunlight 102 enters a multi-band concentrator and energy conversion module 100, the sunlight 102 passes through a multi-band solar concentrator 110, and forms multiple light beams having different bands after the sunlight 102 is split and then concentrated by the multi-band solar concentrator 110. At last, the light beams are incident on an energy conversion device 130.

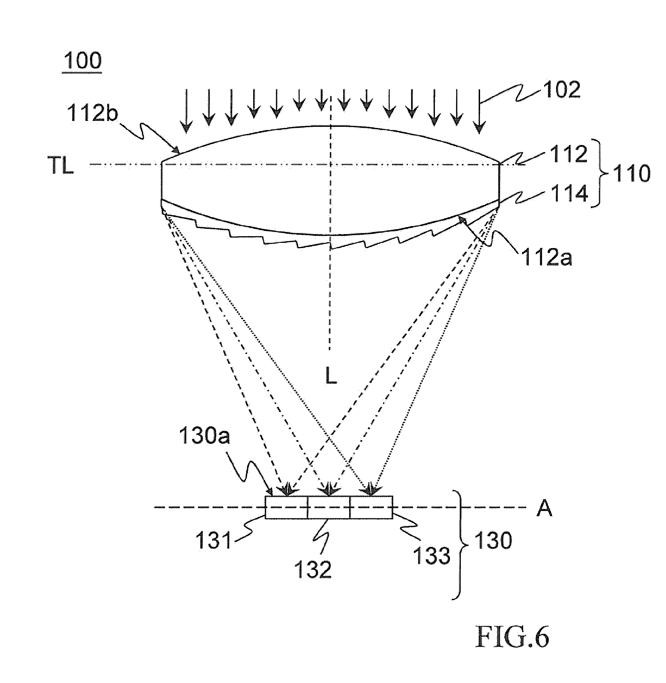

Referring to FIG. 6, which is a schematic structural view of a multi-band concentrator and energy conversion module according to a fourth embodiment. The difference between this embodiment and the embodiment FIG. 3 is that an optic grating 114 is disposed on a light-emitting surface 112a of a light concentration component 112 in this embodiment. Therefore, when sunlight 102 enters a multi-band solar concentrator 110, the sunlight 102 is incident on the light concentration component 112 through an incident surface 112b. After the sunlight 102 is concentrated by the light concentration component 112, the sunlight 102 exits from a light-emitting surface 112a and enters the optic grating 114. Next, the optic grating 114 splits the concentrated sunlight 102 into three light beams having different wavelengths. The light beams are concentrated to different primary spots separated from each other according to different wavelengths (λ₁, λ₂ and λ₃) on a light concentration surface A, and are received by energy conversion units 131, 132, 133 disposed on the corresponding positions. It can be known from the above-mentioned embodiment that in the multi-band solar concentrator 110, the optic grating 114 may be disposed on the incident surface 112a or the light-emitting surface 112b of the light concentration component 112. However, the embodiments are not limited to the above-mentioned arrangements.

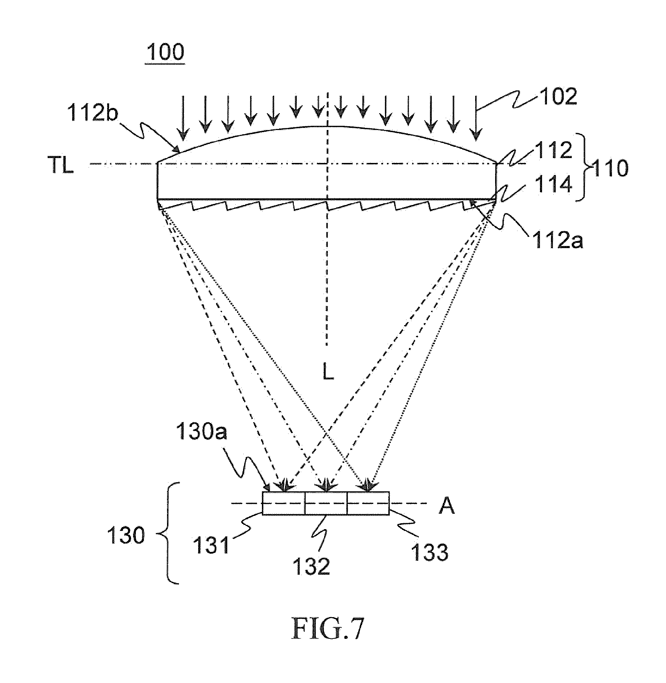

Referring to FIG. 7, which is a schematic structural view of a multi-band concentrator and energy conversion module according to a fifth embodiment. The difference between this embodiment and the embodiment of FIG. 6 is that a light concentration component 112 in this embodiment is a plano-convex lens. An optic grating 114 is disposed on a light-emitting surface 112a (the plane of the plano-convex lens) of the light concentration component 112. In this embodiment, the optic gratings 114 are equal-period optic gratings, that is, periods (pitches) of projections of the optic gratings 114 on tangent lines TL of curved surfaces of the plano-convex lens are all the same. As for the embodiment in FIG. 6, the optic grating 114 is disposed on the light-emitting surface 112a (that is a convex surface of a biconvex lens) of the light concentration component 112, and the optic gratings 114 may be equal-period optic gratings, that is, periods (pitches) of projections of the optic gratings 114 on tangent lines TL of the biconvex lens are all the same. Moreover, the design of the period of a projection of the optic grating 114 on the tangent lines TL to be equal-period is only for example, and persons skilled in the art may know that the period of the optic grating 114 may have variations of different designs, which is not limited thereto.

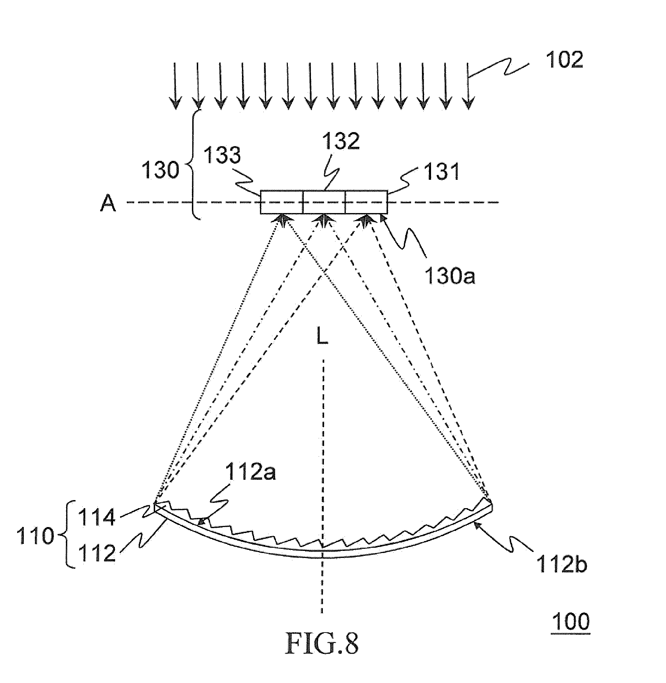

Referring to FIG. 8, which is a schematic structural view of a multi-band concentrator and energy conversion module according to a sixth embodiment shows a multi-band concentrator and energy conversion module 100. Compared with the above embodiments in which the sunlight 102 enters through the light receiving surface 130a of the energy conversion device 130, in this embodiment, the sunlight 102 enters from an inverse direction corresponding to a light receiving surface 130a of an energy conversion device 130 (entering a multi-band solar concentrator 110). Therefore, in this embodiment, a light concentration component 112 may be a reflex light concentration lens, in which a light-emitting surface 112a or an incident surface 112b of the light concentration component 112 may form a reflective surface, and an optic grating 114 is on the light-emitting surface 112a of the light concentration component 112. When the sunlight 102 enters the multi-band solar concentrator 110, the sunlight 102 is split by the optic grating 114, and then, the split light enters the light concentration component 112 to be concentrated. As the light-emitting surface 112a or the incident surface 112b is the reflective surface, the split light beams are reflected toward the light concentration component 112, and are concentrated on a light concentration surface A. Then, the concentrated light enters the energy conversion device 130 on the light concentration surface A. In other embodiments, the multi-band solar concentrator may be formed integrally, that is, the light concentration component 112 and the optic grating 114 are formed into one piece. In the integrated concentrator in this embodiment, a reflecting layer may be disposed on a surface of the optic grating 114, for example, a metal coating on the surface. When the sunlight 102 enters the multi-band solar concentrator 110, the sunlight 102 is directly reflected, concentrated and split in the optic grating 114, and the split and concentrated sunlight 102 may be concentrated on the light concentration surface A in the same manner.

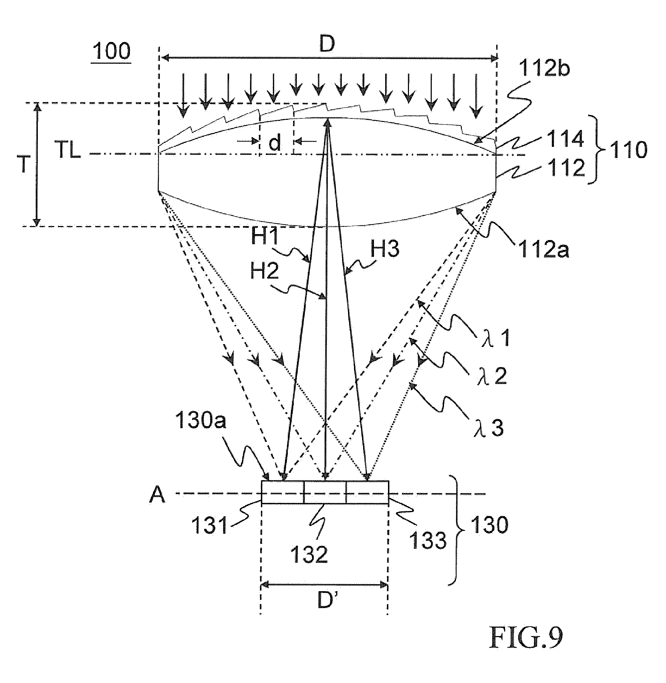

For example, one design of a multi-band concentrator and energy conversion module 100 may be found in FIG. 9, which is a schematic structural view of an example of a multi-band concentrator and energy conversion module according to an embodiment. In this embodiment, a biconvex lens is taken as a light concentration component 112, and an optic grating 114 may split an incident light into three bands being λ₁, λ₂ and λ₃ according to wavelengths, in which λ₁=500 nm, λ₂=600 nm, and λ₃=700 nm. Energy conversion units 131, 132, 133 disposed correspondingly at positions of primary spots of a light concentration surface A have good absorption coefficients to the band lights having the wavelengths of 500 nm, 600 nm and 700 nm. When sunlight 102 is vertically incident, the width D and thickness T of the light concentration component 112 are 8 cm and 1 cm respectively; an index of refraction of material used by the light concentration component 112 is 1.49; a curvature radius (R) of the light concentration component 112 is 12.8 cm; a period d of a projection of the optic grating on a tangent line TL is 5 mm; a diffraction order of the optic grating 114 is -1; the total width D' of an energy conversion device 130 is 1.5 cm and lengths of links H1, H2, and H3 from a central point of an incident surface 112b of the light concentration component 112 to central points of light receiving surfaces 130a of the energy conversion units 131, 132, 133 are 27.60 cm, 27.63 cm and 27.66 cm respectively; and angles between the links H1, H2, and H3 and a normal line of the light receiving surface 130a are 5.74°, 6.89°, and 8.05° respectively.

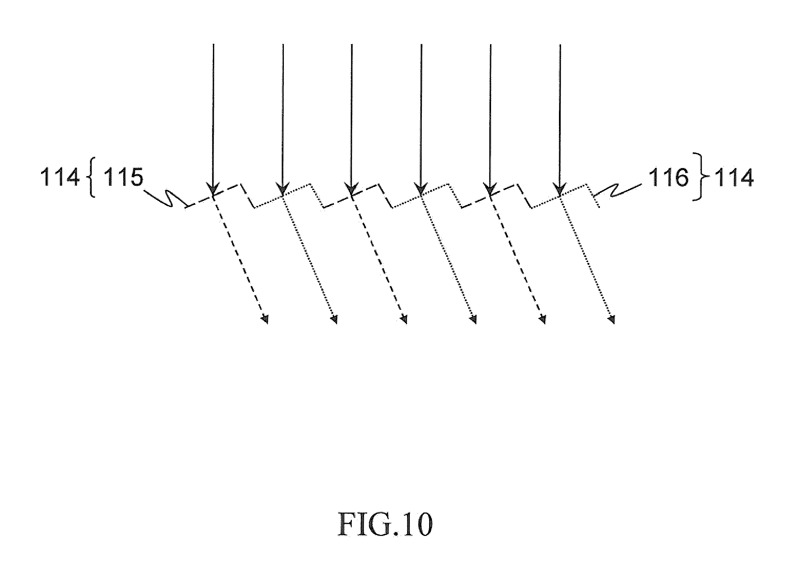

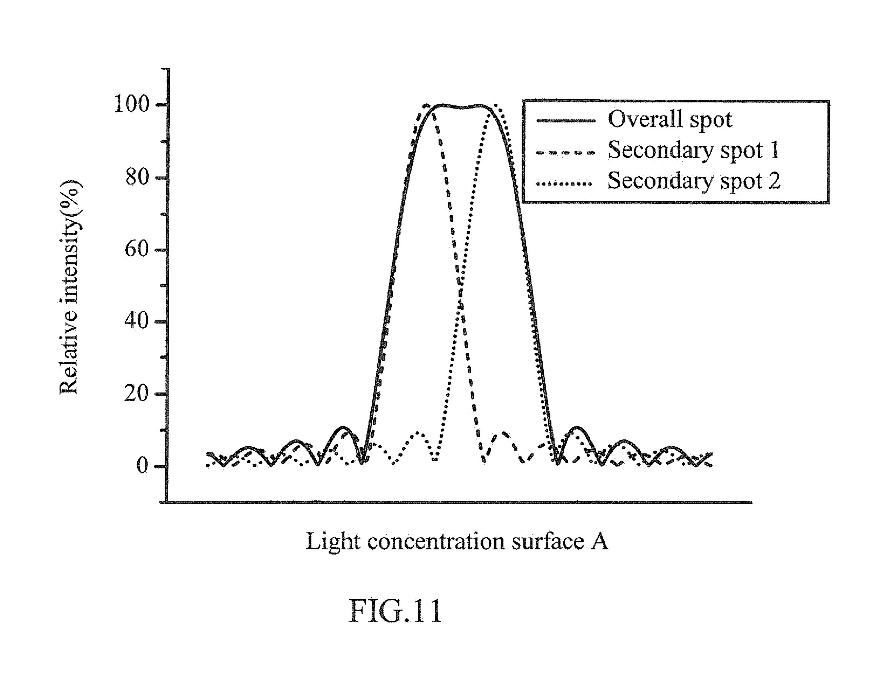

Furthermore, please refer to FIG. 10, which is a detailed schematic structural view of an optic grating according to an embodiment. An optic grating 114 may comprise more than two secondary optic gratings 115 and 116. The secondary optic gratings 115 and 116 are staggered to each other. Moreover, the secondary optic gratings 115 and 116 may have the same period, or have different periods, and may have different designs according to actual requirements. In this embodiment, the secondary optic gratings 115 and 116 may enable an incident light to form secondary spots thereof on a light concentration surface A so that an overall spot with a flat center through overlapping of the secondary spots is obtained, and further to avoid excessively concentration of energy. In other words, each of the primary spots corresponding to energy conversion units 131, 132, 133 may be comprise more than two secondary spots, so as to avoid a rise of temperature of an energy conversion device 130 caused by the excessively concentrated energy. A reference of a schematic view of the secondary spots and the overall spot is made to FIG. 11 (FIG. 11 is a schematic view of secondary spots and an overall spot according to an embodiment). In the figure, the horizontal axis is a horizontal position of a light concentration surface A, and the vertical axis is relative intensity. As shown, multiple secondary spots adjacent to each other are concentrated to be a primary spot (or called as overall spot, in the figure, only the secondary spots 1 and 2 are shown, but not limited to the embodiments).

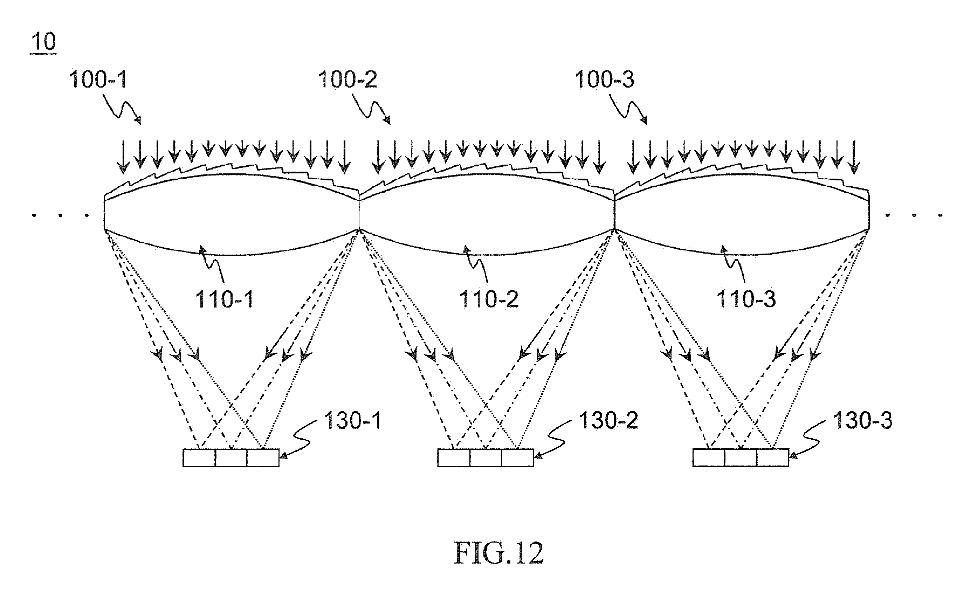

Referring to FIG. 12, which is a schematic structural view of multiple multi-band concentrator and energy conversion modules according to the first embodiment. In a solar power system 10, more than two multi-band concentrator and energy conversion modules 100-1, 100-2, and 100-3 are disposed.

The multi-band concentrator and energy conversion modules 100-1, 100-2, and 100-3 may be disposed in parallel. That is to say, multi-band solar concentrators 110-1, 110-2, and 110-3 of the multi-band concentrator and energy conversion modules 100-1, 100-2, and 100-3 are sequentially disposed with sides adjacent to each other. Energy conversion devices 130-1, 130-2, and 130-3 of the different multi-band concentrator and energy conversion modules 100-1, 100-2, and 100-3 are not adjacent to each other, in other words, separated to each other.

According to the multi-band concentrator and energy conversion module of the embodiment, a multi-band solar concentrator (a light concentration component and an optic grating) is used for splitting sunlight to light beams having different bands, and concentrating the light to the corresponding energy conversion units, so as to enable the energy conversion unit to have a good conversion efficiency, thereby improving the total energy conversion efficiency. Furthermore, the use of the multi-band solar concentrator may further reduce the use of energy conversion unit material.

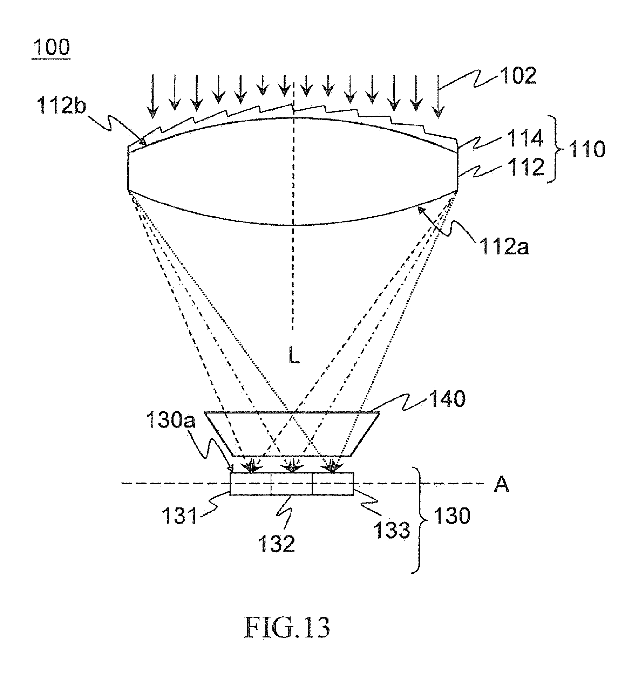

Finally, referring to FIG. 13, a schematic structural view of a multi-band concentrator and energy conversion module according to a seventh embodiment is shown. The multi-band concentrator and energy conversion module 100 comprises a multi-band solar concentrator 110, an energy conversion device 130, and a secondary lens 140 disposed between the multi-band solar concentrator 110 and the energy conversion device 130. The multi-band solar concentrator 110 comprises an optic grating 114 and a light concentration component 112. The optic grating 114 splits the incident light 102 into light beams. The light concentration component 112 of the multi-band solar concentrator 110 concentrates the light beams on a light concentration surface A. The secondary lens 140 is used for guiding the split and concentrated light beams to multiple spots. Therefore, after being concentrated, the light beams pass the secondary lens 140, a deviation of an incident angle of the light beams incident on the energy conversion device 130 may be reduced, thus avoiding a deviation of the spots from the energy conversion device 130. Therefore, the energy conversion device 130 may perform the energy conversion on the incident light according to the absorption bands.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to activate others skilled in the art to utilize the disclosure and various embodiments and with various modifications as are suited to the particular use contemplated. Alternative embodiments will become apparent to those skilled in the art to which the disclosure pertains without departing from its spirit and scope. Accordingly, the scope of the disclosure is defined by the appended claims rather than the foregoing description and the exemplary embodiments described therein.

## Claims

1. A multi-band concentrator and energy conversion, module (100), **characterized by**:
a multi-band solar concentrator (110), for splitting an incident light (102) into a plurality of light beams and concentrating the plurality of light beams on a plurality of primary spots separated from each other, respectively; and
an energy conversion device (130), comprising a plurality of energy conversion units (131, 132, 133) being corresponding to and disposed at the primary spots separated from each other individually, wherein each of the energy conversion units (131,132,133) has an individual absorption spectrum peak corresponding to a wavelength of the light beam of the primary spot where the energy conversion unit (131, 132, 133) is disposed.

2. The multi-band concentrator and energy conversion module (100) according to claim 1, wherein the multi-band solar concentrator (110) comprises:
an optic grating (114), for splitting the incident light (102) according to the wavelengths, so as to form the light beams; and
a light concentration component (112), for concentrating the light beams on the primary spots separated from each other.

3. The multi-band concentrator and energy conversion module (100) according to claim 2, wherein the optic grating (114) comprises a plurality of secondary optic gratings (115,116) staggered to each other.

4. The multi-band concentrator and energy conversion module (100) according to claim 1, wherein the multi-band solar concentrator (110) comprises:
a light concentration component (112), for concentrating the incident light (102); and
an optic grating (114), for splitting the concentrated light into the light beams on the primary spots separated from each other according to wavelengths.

5. The multi-band concentrator and energy conversion module (100) according to claim 4, wherein the optic grating (114) comprises a plurality of secondary optic gratings (115,116) for splitting the concentrated light on a plurality of secondary spots, and each of the primary spots comprises two of the secondary spots.

6. The multi-band concentrator and energy conversion module (100) according to claim 1, further comprising a secondary lens (140) disposed between the multi-band solar concentrator (110) and the energy conversion device (130), and the secondary lens (140) for guiding the split and concentrated light to the primary spots separated from each other.

7. A multi-band concentrator and energy conversion module (100), **characterized by**:
a multi-band solar concentrator (110), comprising:
a light concentration component (112); and
an optic grating (114), disposed on a surface of the light concentration component (112); and
an energy conversion device (130), comprising a plurality of energy conversion units (131,132,133) disposed on a light concentration surface (A) of the light concentration component (112) with sides adjacent to each other, wherein a light receiving surface (130a) of the energy conversion units (131,132,133) faces the light concentration component (112).

8. The multi-band concentrator and energy conversion module (100) according to claim 7, wherein the light concentration surface (A) of the light concentration component (112) forms an angle with an optical axis of the light concentration component (112), and the angle is between 60° and 120°.

9. The multi-band concentrator and energy conversion module (100) according to claim 7, wherein the light concentration component (112) is used for concentrating an incident light (102) to be incident on the energy conversion units (131,132,133) with an incident angle of between -30° and 30°.

10. The multi-band concentrator and energy conversion module (100) according to claim 7, wherein the area of a light-emitting surface (112a) of the light concentration component (112) has a size capable of covering the light receiving surface (130a) of the energy conversion device (130).

11. The multi-band concentrator and energy conversion module (100) according to claim 10, wherein the width of the energy conversion device (130) is less than or equal to a half of the width of the light concentration component (112).

12. The multi-band concentrator and energy conversion module (100) according to claim 10, wherein the light receiving surface (130a) of the energy conversion device (130) is less than or equal to a half of the area vertically projected on a horizontal surface by the light-emitting surface (112a) of the light concentration component (112).

13. The multi-band concentrator and energy conversion module (100) according to claim 7, wherein the light concentration component (112) comprises a light-emitting surface (112a) and an incident surface (112b), and the optic grating (114) is disposed on the incident surface (112b) or the light-emitting surface (112a) of the light concentration component (112).

14. The multi-band concentrator and energy conversion module (100) according to claim 7, wherein the light concentration component (112) is a lens, and the lens is a biconvex lens, a plano-convex lens, a Fresnel lens, or a reflex light concentration lens.

15. The multi-band concentrator and energy conversion module (100) according to claim 7, further comprising a secondary lens (140), wherein the secondary lens (140) is disposed between the multi-band solar concentrator (110) and the energy conversion device (130).

16. A multi-band concentrator and energy conversion module (100), **characterized by**:
a multi-band solar concentrator (110), for splitting and concentrating an incident light (102) according to wavelengths, and the multi-band solar concentrator (110) comprising:
a light concentration component (112), for concentrating the incident light (102) on a light concentration surface (A); and
an optic grating (114), for splitting the incident light (102) according to bands; and
an energy conversion device(130), comprising a plurality of energy conversion units (131,132,133) disposed on the light concentration surface (A) of the light concentration component (112), wherein a light receiving surface (130a) of the energy conversion device (130) faces the light concentration component (112);
wherein after being split and being concentrated by the multi-band solar concentrator (110), the incident light (102) forms a plurality of light beams having the bands different from each other to be incident on the energy conversion device (130).

17. The multi-band concentrator and energy conversion module (100) according to claim 16, wherein an angle between a central axis of the light receiving surface (130a) of each of the energy conversion units (131,132,133) and an optical axis of each corresponding light beam is between 0° and 20°.

18. The multi-band concentrator and energy conversion module (100) according to claim 16, wherein the light concentration component (112) comprises a light-emitting surface (112a) and an incident surface (112b), and the optic grating (114) is disposed on the incident surface (112b) or the light-emitting surface (112a).

19. The multi-band concentrator and energy conversion module (100) according to claim 16, wherein the light beams having the different bands are concentrated to primary spots separated from each other on the light concentration surface (A), and the energy conversion units (131,132,133) are disposed on the primary spots separated from each other.

20. The multi-band concentrator and energy conversion module (100) according to claim 19, wherein the energy conversion units (131,132,133) have different absorption spectra according to the incident light (102), and the energy conversion units (131,132,133) are disposed on the primary spots of the light beams separated from each other having the bands different from each other corresponding to the absorption spectra of the energy conversion units (131,132,133).

21. The multi-band concentrator and energy conversion module (100) according to claim 16, further comprising a secondary lens (140), wherein the secondary lens is disposed between the multi-band solar concentrator (110) and the energy conversion device (130).
